Europäisches Patentamt

European Patent Office

Office européen des brevets

(19)

(11) **EP 1 115 209 A1**

(12) **EUROPEAN PATENT APPLICATION**

(43) Date of publication:
**11.07.2001 Bulletin 2001/28**

(51) Int Cl.$^7$: **H03M 13/29**

(21) Application number: **00100349.0**

(22) Date of filing: **07.01.2000**

(84) Designated Contracting States:
**AT BE CH CY DE DK ES FI FR GB GR IE IT LI LU MC NL PT SE**
Designated Extension States:
**AL LT LV MK RO SI**

(71) Applicant: **MOTOROLA, INC.**
**Schaumburg, IL 60196 (US)**

(72) Inventors:
• **Chass, Amir**
**Ramat Hasharon 47204 (IL)**
• **Gubeskys, Arik**
**Rosh Ha'yin (IL)**

(74) Representative: **Richardt, Markus Albert**
**Motorola GmbH,**
**Hagenauerstrasse 47**
**65203 Wiesbaden (DE)**

(54) **Apparatus and method for performing parallel siso decoding**

(57)     A device and method for performing SISO coding in a parallel manner. Forward metrics and backward metrics computed in parallel. When forward metrics of nodes of a stage are computed and backward metrics of nodes of an adjacent stage were previously computed, the computation of forward metrics is integrated with the computation of a lambda from the stage to the adjacent stage, wherein when backward metrics of nodes of a stage are computed and the forward metrics of the nodes of an adjacent stage were previously computed, the computation of backward metrics is integrated with the computation of lambda from the stage to the adjacent stage.

FIG. 1

**Description**

**Field of the invention**

Apparatus and method for performing parallel SISO decoding, and especially an apparatus and method for performing maximum a posteriori (i.e - MAP) decoding algorithms that involve calculating in a parallel manner forward metrics and backward metrics.

BACKGROUND OF THE INVENTION

Turbo Coding (i.e.- TC) is used for error control coding in digital communications and signal processing. The following references give some examples of various implementations of the TC: "Near Shannon limit error correcting coding and decoding: turbo-codes", by Berrou, Glavieux, Thitimajshima, IEEE International Conference of Communication. Geneva Switzerland, pp. 1064-1070, May 1993; "Implementation and Performance of a Turbo/MAP Decoder", Pietrobon, International Journal of Satellite Communication; "Turbo Coding", Heegard and Wicker, Kluwer Academic Publishers 1999.

MAP algorithm and soft output Viterbi algorithm (SOVA) are Soft Input Soft Output (i.e.- SISO) decoding algorithms that have gained wide acceptance in the area of communications. Both algorithms are mentioned in U.S patent 5,933,462 of Viterbi et al.

The TC has gained wide acceptance in the area of communications, such as in cellular networks, modems, and satellite communications. Some turbo encoders consists of two parallel-concatenated systematic convolutional encoders separated by a random interleaver. A turbo decoder has two soft-in soft-out (SISO) decoders. The output of the first SISO is coupled to the input of the second SISO via a first interleaver, while the output of the second SISO is coupled to an input of the first SISO via a feedback loop that includes a deinterleaver.

A common SISO decoder uses either a maximum a posteriori (i.e.- MAP) decoding algorithm or a Log MAP decoding algorithm. The latter algorithm is analogues to the former algorithm but is performed in the logarithmic domain. Briefly, the MAP finds the most likely information bit to have been transmitted in a coded sequence.

The output signals of a convolutional encoder are transmitted via a channel and are received by a receiver that has a turbo decoder. The channel usually adds noise to the transmitted signal.

During the decoding process a trellis of the possible states of the coding is defined. The trellis includes a plurality of nodes (states), organized in T stages, each stage has $N=2^{sup(K-1)}$ nodes, whereas T being the number of received samples taken into account for evaluating which bit was transmitted from a transmitter having the convolutional encoder and K is the constraint length of the code used for encoding. Each stage is comprised of states that represent a given time. Each state is characterized by a forward state metric, commonly referred to as alpha ($\alpha$ or a) and by a backward state metric, commonly referred to as beta ($\beta$ or b). Each transition from a state to another state is characterized by a branch metric, commonly referred to as gamma ($\gamma$).

Alphas, betas and gammas are used to evaluate a probability factor that indicates which signal was transmitted. This probability factor is commonly known as lambda ($\Lambda$). A transition from a stage to an adjacent stage is represented by a single lambda.

The articles mentioned above describe prior art methods for performing MAP algorithm, these prior art methods comprise of three steps. During the first step the alphas that are associated with all the trellis states are calculated, starting with the states of the first level of depth and moving forward. During the second step the betas associated with all the trellis states are calculated, starting with the states of the L'th level of depth and moving backwards. Usually, while betas are calculated the lambdas can also be calculated. Usually, the gammas are calculated during or even before the first step.

The TC can be implemented in hardware or in software. When implemented in hardware, the TC will generally run much faster than the TC implemented in software. However, implementing the TC in hardware is more expensive in terms of semiconductor surface area, complexity, and cost.

The prior art solution is of a serial nature and is relatively time consuming. There is a need to provide an improved method and apparatus for performing fast and efficient SISO encoding.

U.S patent 5,933,462 of Viterbi describes a soft decision output decoder for decoding convolutionally encoded code words. The decoder is based upon "generalized" Viterbi decoders and a dual maxima processor. The decoder has various drawbacks, such as, but not limited to the following drawbacks: The decoder either has a single backward decoder or two backward decoders. In both cases, and especially in the case of a decoder with one backward decoder, the decoder is relatively time consuming. In both cases, a learning period L equals a window W in which valid results are provided by backward decoder and forward decoder. Usually, L<W and the decoder described in U.S. patent 5,933.462 is not effective. The decoder described in U.S. patent 5,933,462 is limited to calculate state metrics of nodes over a window having a length of 2L, where L is a number of constraint lengths, 2L is smaller than block length T of the trellis. Furthermore,

There is a need to provide an improved device and method for performing SISO coding in a fast and efficient manner. There is a need to provide a method for performing SISO coding in a parallel systems such as long instruction word systems.

BRIEF DESCRIPTION OF THE DRAWINGS

While the invention is pointed out with particularity in the appended claims, other features of the invention are disclosed by the following detailed description taken in conjunction with the accompanying drawings, in which:

FIGS. 1-5 illustrates in flow chart form, a method for performing a SISO coding, in accordance with a preferred embodiment of the present invention;
FIGS. 6-7 are schematic descriptions of systems for decoding a sequence of signals output by a SISO encoder and transmitted over a channel according to a preferred embodiment of the invention;
FIG. 8 is a block diagram of a data processing system, according to an embodiment of the invention;
FIG. 9 is a diagram that illustrates registers within the core of the system of FIG. 8;
FIG. 10 is a schematic diagram of the data register files, four arithmetic logic units and a shifter/limiter;
FIG. 11 is a diagram that illustrates a particular embodiment of the one of the MAC units of FIG. 8; and
FIG. 12 is a diagram that illustrates a dispatch unit, and a dispatch operation for the core of the system of FIG. 8.

DESCRIPTION OF THE PREFERRED EMBODIMENT

It should be noted that the particular terms and expressions employed and the particular structural and operational details disclosed in the detailed description and accompanying drawings are for illustrative purposes only and are not intended to in any way limit the scope of the invention as described in the appended claims.

The invention provides an improved device and method for performing SISO decoding in a fast and efficient manner. Alphas and betas are computed in a parallel manner, either in over the whole trellis or over two windows. When alphas and betas are computed over the whole trellis, the alphas are computed from the beginning of the trellis and the betas from the end of the trellis. There is no need to undergo a learning period. When alphas (betas) of nodes of a stage are computed and the betas (alphas) of the nodes of an adjacent stage were previously computed, the computation of alphas (betas) is integrated with the computation of lambda from the stage to the adjacent stage. When alpha and beta are computed over two windows or two groups of windows in parallel, a learning period is undergone before the alphas and betas of the windows are computed. Conveniently, the learning periods are much shorter than the windows.

The invention provides a method for performing SISO coding in a parallel systems such as long instruction word processors. Long instruction word processors allow to perform parallel computations of alphas, betas and lambdas. Such an implementation is based upon a plurality of instructions.

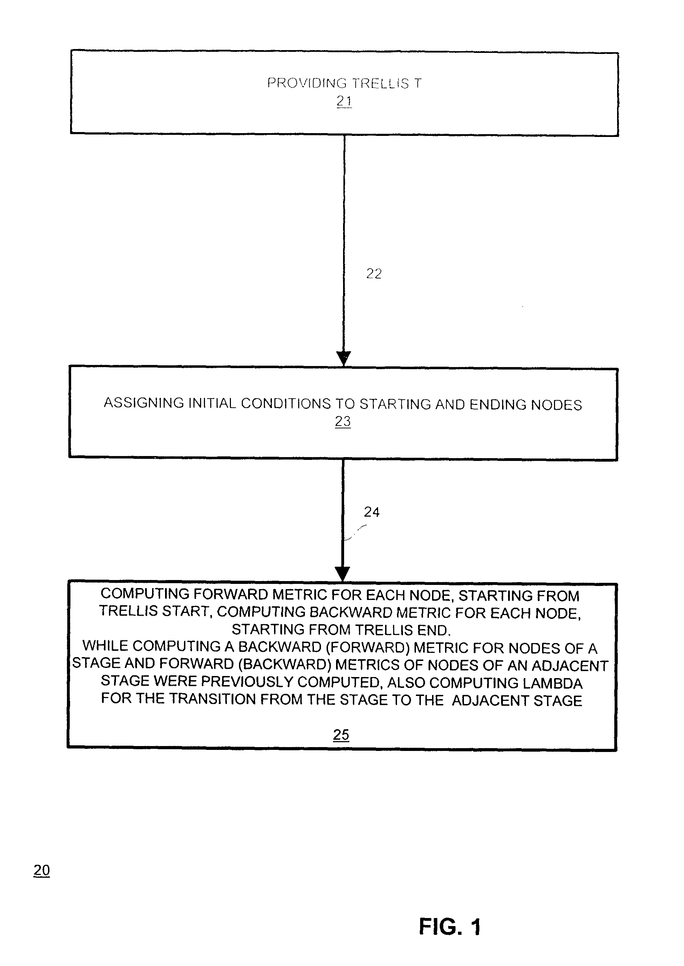

FIG. 1 is a simplified flow chart diagram illustrating method 20 of the present invention. Preferably, method 20 comprises steps 21, 23 and 25, illustrated by blocks. Solid lines 22 and 24, coupling the steps indicate a preferred method flow. Method 20 requires that the entire trellis is stored. It is very fast and it does not involve any learning period.

Method 20 starts with step 21 of providing a trellis representative of an output of a SISO encoder, the trellis having a block length T.

Step 21 is followed by step 23 of assigning an initial conditions to each starting node of the trellis for a forward iteration through the trellis and assigning an initial condition to each ending node of the trellis for a backward iteration through the trellis.

Step 23 is followed by step 25 of computing a forward metric for each node, starting from the start of the trellis and advancing forward through the trellis and in parallel computing a backward metric for each node, starting from the end of the trellis and advancing backwards through the trellis. Wherein when alphas (betas) of nodes of a stage are computed and the betas (alphas) of the nodes of an adjacent stage were previously computed, the computation of alphas (betas) is integrated with the computation of lambda from the stage to the adjacent stage.

Conveniently, gammas are calculated during step 25. Preferably, method 20 is used to implement the Max Log MAP algorithm or the Log MAP algorithm. For convenience of explanation both algorithms are referred to as Log MAP algorithms.

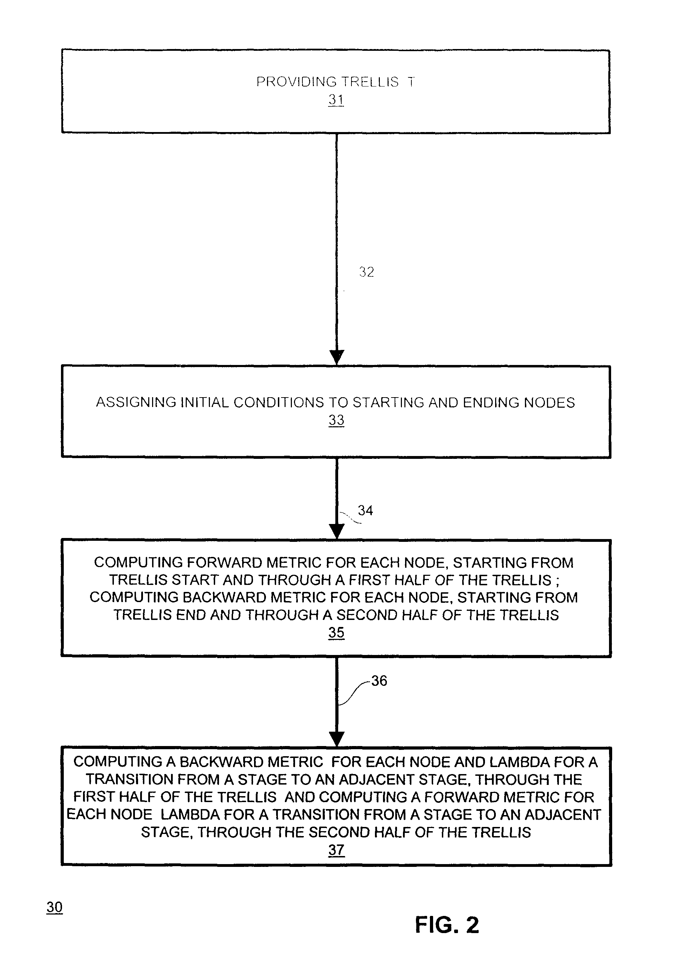

FIG. 2 is a simplified flow chart diagram illustrating method 30 of the present invention. Preferably, method 30 comprises steps 31, 33, 35 and 37, illustrated by blocks. Solid lines 32, 34 and 36, coupling the steps indicate a preferred method flow. Method 30 requires that the entire trellis is stored. It is very fast and it does not involve any learning period.

Method 30 starts at step 31 of providing a trellis representative of an output of a SISO encoder, the trellis having a block length T.

Step 31 is followed by step 33 of assigning an initial conditions to each starting node of the trellis for a forward iteration through the trellis and assigning an initial condition to each ending node of the trellis for a backward iteration through the trellis.

Step 33 is followed by step 35 of computing a forward metric for each node, starting from the start of the trellis and advancing forward through a first half of the trellis and a backward metric for each node, starting from the end of the trellis and advancing backwards through a second half of the trellis.

Step 35 is followed by step 37 of computing a backward metric for each node, and a lambda for each transition from a stage to an adjacent stage, starting from an end of the first half of the trellis and advancing backwards and computing a forward metric for each node and a lambda for each transition from a stage to an adjacent stage, starting from a start of the second half of the trellis and advancing forwards.

Conveneintly, gammas are calculated during step 35. Preferably, method 30 is used to implement the Log MAP algorithms.

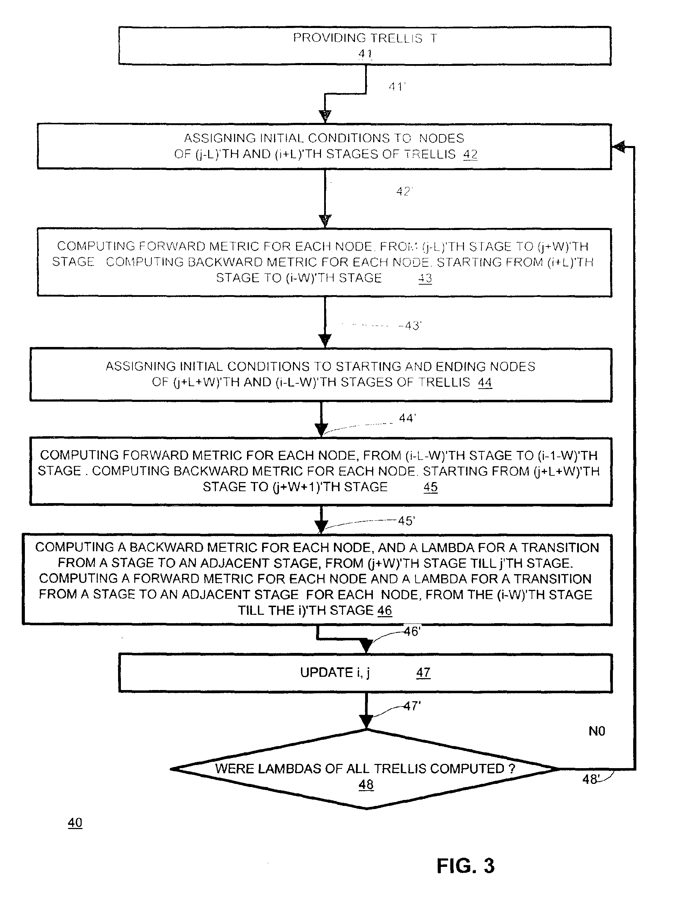

FIG. 3-5 describe methods 40-60 for performing SISO decoding, whereas only a portion of a trellis is stored in memory.

FIG. 3 is a simplified flow chart diagram illustrating method 40 of the present invention. Preferably, method 40 comprises steps 41, 42, 43, 44, 45, 46 and 47, illustrated by blocks. Solid lines 41', 42', 43', 44', 45', 46' and 47', coupling the steps indicate a preferred method flow, Method 20 requires that only a portion of the trellis is stored. It is very fast but it requires to undergo a learning period. Conveniently; the learning period L is much shorter than a window W in which valid alphas and betas are computed.

Method 40 starts with step 41 of providing a trellis representative of an output of a convolutional encoder, the trellis having a block length T.

Step 41 is followed by step 42 of assigning an initial condition to each node of a (j-L)'th stage of the trellis for a forward iteration through the trellis and assigning an initial condition to each node of a (i +L)'th stage of the trellis for a backward iteration through the trellis; wherein L is a length of a learning period, a forward window of length W starts at a j'th stage of the trellis and ends at a (j+W)'th stage of the trellis, a backward window of length W starts at a i'th stage of the trellis and ends at a (i-W)'th stage of the trellis.

Step 42 is followed by step 43 of computing a forward metric for a each node, starting from the (j-L)'th stage of the trellis and ending at the (j+W)'th stage of the trellis and computing a backward metric of a plurality each node, starting from the (i +L)'th stage of the trellis and ending at the (i-W)'th stage of the trellis.

Step 43 is followed by step 44 of assigning an initial condition to each node of a (j+L+W)'th stage of the trellis for a backward iteration through the trellis and assigning an initial condition to each node of a (i-W-L)'th stage of the trellis for a forward iteration through the trellis.

Step 44 is followed by step 45 of computing a backward metric for each node. starting from the (j+L+W)'th stage of the trellis and ending at the (j+W+1)'th stage of the trellis and computing a forward metric of each node, starting from the (i-L-W)'th stage of the trellis and ending at the (i-1-W)'th stage of the trellis.

Step 45 is followed by step 46 of computing a backward metric for each node and a lambda for each transition from a stage to an adjacent stage, starting from the (j+W)'th stage and ending at the j'th stage and computing a forward metric for each node and a lambda for each transition from a stage to an adjacent stage, starting from the (1-W)'th stage and ending at the i'th stage of the trellis..

Step 46 is followed by step 47 of updating j and i.

Step 47 is followed by query step 48 of checking if each lambda of the trellis is calculated. If the answer is yes, the process ends. Else, step 47 is followed by step 42.

Preferably, method 40 is used to implement the Log MAP algorithms. Conveniently, gammas are calculated during steps 43 and 44.

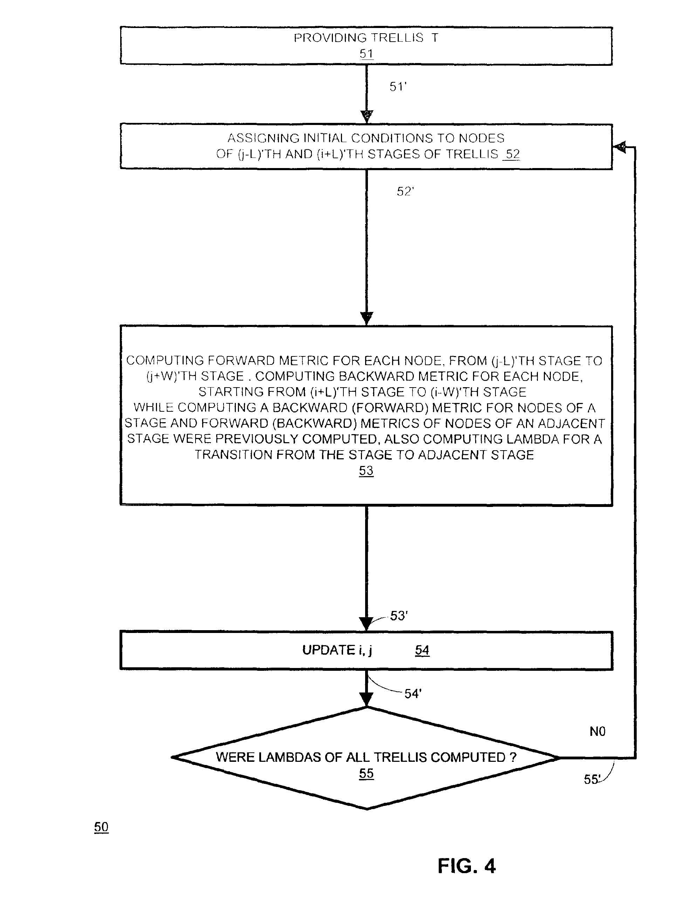

FIG. 4 is a simplified flow chart diagram illustrating method 50 of the present invention. Preferably, method 50 comprises steps 51-55, illustrated by blocks. Solid lines 51'-55' coupling the steps indicate a preferred method flow. Method 50 requires that only a portion of the trellis is stored. It is very fast but it requires to undergo a learning period. Conveniently, the learning period L are much shorter than a window W in which valid alphas and betas are computed.

Method 50 starting at step 51 of providing a trellis representative of an output of a convolutional encoder, the trellis having a block length T;

Step 51 is followed by step 52 of assigning an initial condition to each node of a (j-L)'th stage of the trellis for a forward iteration through the trellis and assigning an initial condition to each node of a (i +L)'th stage of the trellis for a backward iteration through the trellis; wherein L is a length of a learning period, a forward window of length W starts at a j'th stage of the trellis and ends at a (j+W)'th stage of the trellis, a backward window of length W starts at a i'th stage of the trellis and ends at a (i-W)'th stage of the trellis;

Step 52 is followed by step 53 of computing a forward metric for a each node, starting from the (j-L)'th stage of the trellis and ending at the (j+W)'th stage of the trellis and computing a backward metric of a plurality each node, starting from the (i +L)'th stage of the trellis and ending at the (i-W)'th stage of the trellis. Wherein when alphas (betas) of nodes of a stage are computed and the betas (alphas) of the nodes of an adjacent stage were previously computed, the computation of alphas (betas) is integrated with the computation of lambda from the stage to the adjacent stage.

Step 53 is followed by step 54 of updating j and i.

Step 54 is followed by query step 55 of checking if each lambda of the trellis is calculated. If the answer is yes, the process ends. Else, step 54 is followed by step 52.

Preferably, method 50 is used to implement the Log MAP algorithms. Conveniently, gammas are calculated during step 53.

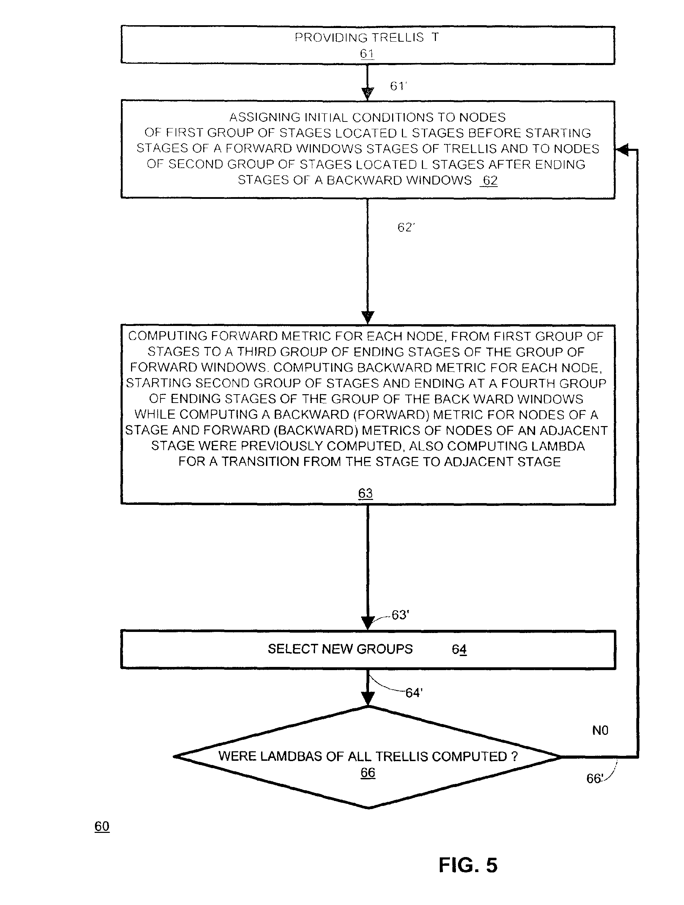

FIG. 5 is a simplified flow chart diagram illustrating method 60 of the present invention. Preferably, method 60 comprises steps 61-65, illustrated by blocks. Solid lines 61'-65' coupling the steps indicate a preferred method flow. Method 60 requires that only a portion of the trellis is stored. It is very fast but it requires to undergo a learning period. Conveniently, the learning period L are much shorter than a window W in which valid alphas and betas are computed.

Method 60 starting at step 61 of providing a trellis representative of an output of a convolutional encoder, the trellis having a block length T;

Step 61 is followed by step 62 of assigning an initial condition for forward iteration through the trellis, to each node of a first group of stages, each stage located L stages before a starting stage of a forward window out of a group of forward windows, and assigning an initial condition for a backward iteration through the trellis, to each node of a second group of stages, each stage located L stages after an ending stage of a backward window out of a group of backward windows, wherein L is a length of a learning period, each forward window and each backward window is W stages long.

Step 62 is followed by step 63 of computing a forward metric for a each node, starting from the first group of stages and ending at a third group of ending stages of the group of forward windows, and computing a backward metric for each node, starting from second group of stages and ending at a fourth group of ending stages of the group of the backward windows. Wherein when alphas (betas) of nodes of a stage are computed and the betas (alphas) of the nodes of an adjacent stage were previously computed, the computation of alphas (betas) is integrated with the computation of lambda from the stage to the adjacent stage

Step 63 is followed by step 64 of selecting new groups.

Step 64 is followed by query step 65 of selecting new groups and checking if each lambda of the trellis is calculated. If the answer is yes, the process ends. Else, step 65 is followed by step 62.

In reference to method 40-60, if any of the variables within brackets, such as (j-L). (i+L) are either negative or greater than T they are mapped accordingly to either 0 or T. For example, if j=1 and L=5 than during step 42 initial conditions are assigned to the nodes of the starting stage of the trellis. Furthermore, in such a case there is no need to perform a learning period during step 43.

Conveniently, the steps of calculating alphas and betas of methods 40-60 are executed after receiving enough signal samples to initiate a backward and forward recursion through the trellis. Preferably, these steps are executed after receiving T/R signals, R being the coding rate of a convolutional encoder that its output signals are represented by the trellis. Conveniently, the steps of calculating alphas and betas of methods 20-30 are executed after receiving T/R signals.

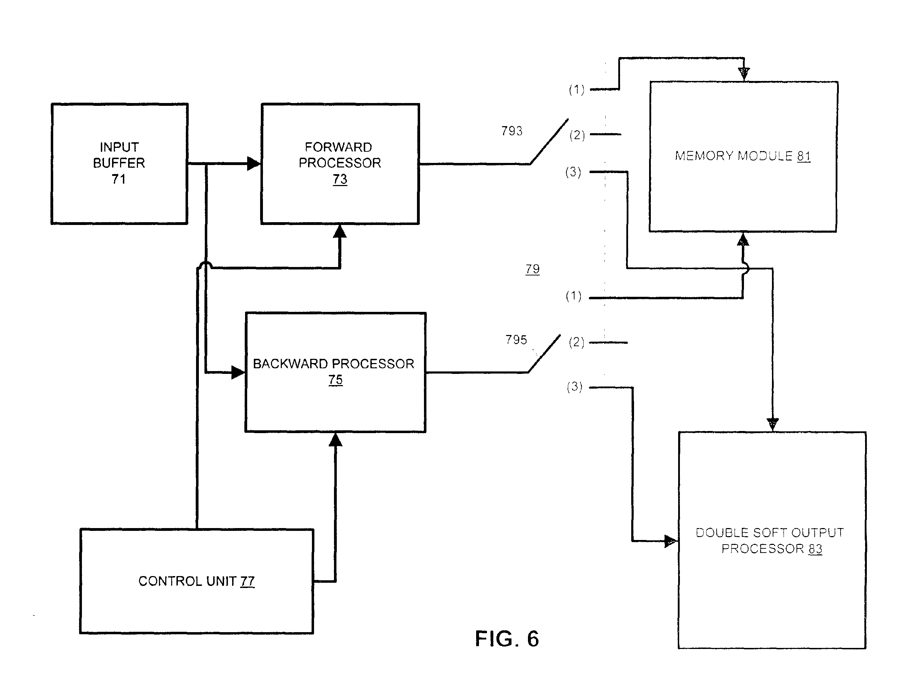

FIG. 6 is a schematic description of system 70 for decoding a sequence of signals output by a convolutional encoder and transmitted over a channel according to a preferred embodiment of the invention. System 70 comprising input buffer 71, forward processor 73, backward processor 75, control unit 77, switching unit 79 memory module 81 and a double soft output processor 83. Input buffer 71 is adapted to receive the sequence of signals and provide them to forward processor 73 and backward processor 75. Forward processor 73 is adapted to receive the sequence of signals from input buffer and compute forward metrics (alphas). Backward processor 75 is adapted to receive the sequence of signals from input buffer 71 and compute backward metrics (betas).

Conveniently, switching unit 79 comprises of two switches - forward switch 793 and backward switch 795. According to control signals from control unit 77, forward switch 793 can couple the output of forward processor 73 to memory module 81 (state "1"), to double soft output processor 83 (state "3") or can isolate the output of forward processor 73 (state "2"). According to control signals from control unit 77, backward switch 795 can couple the output of backward processor 75 to memory module 81 (state "1"), 10 double soft output processor 83 (state "3") or can isolate the output of backward processor 75 (state "2").

During learning periods of forward and backward processors 73 and 75 the alphas and betas are not valid. Conveniently they are not stored in memory module 81. Preferably, during learning periods, control unit 77 sends control signals to switching unit 79 so that the outputs backward processor 75 and forward processor 73 are isolated - they arc not coupled to memory module 81 and double soft output processor 83. Both switches are at state "2".

When forward processor 73 computes alphas of nodes of a stage and the betas of the adjacent stage haven't been previously computed the alphas are sent to memory module 81. Conveniently, forward switch 793 is at state "1" and the output of forward processor 73 is coupled to memory module 81.

When backward processor 75 computes betas of nodes of a stage and the alphas of the adjacent stage haven't been previously computed the betas are sent to memory module 81. Conveniently, backward switch 795 is at state "1" and the output of backward processor.73 is coupled to memory module 81.

When forward processor 73 computes alphas of nodes of a stage and the betas of the adjacent stage have been previously computed, the alphas are sent to double soft output processor 83. Double soft output processor 83 reads the betas of these nodes from memory module and computes lambda. Forward switch 793 is at state "3" and the output of forward processor 73 is coupled to dual soft output processor 83.

When backward processor 75 computes betas of nodes of a stage and the alphas of the adjacent stage have been previously computed the betas are sent to double soft output processor 83. Double soft output processor 83 reads the alphas of these nodes from memory module 81 and computes lambda. Backward switch 795 is at state "3" and the output of backward processor 75 is coupled to dual soft output processor 83.

Double soft output processor 83 is adapted to calculate two lambdas in parallel.

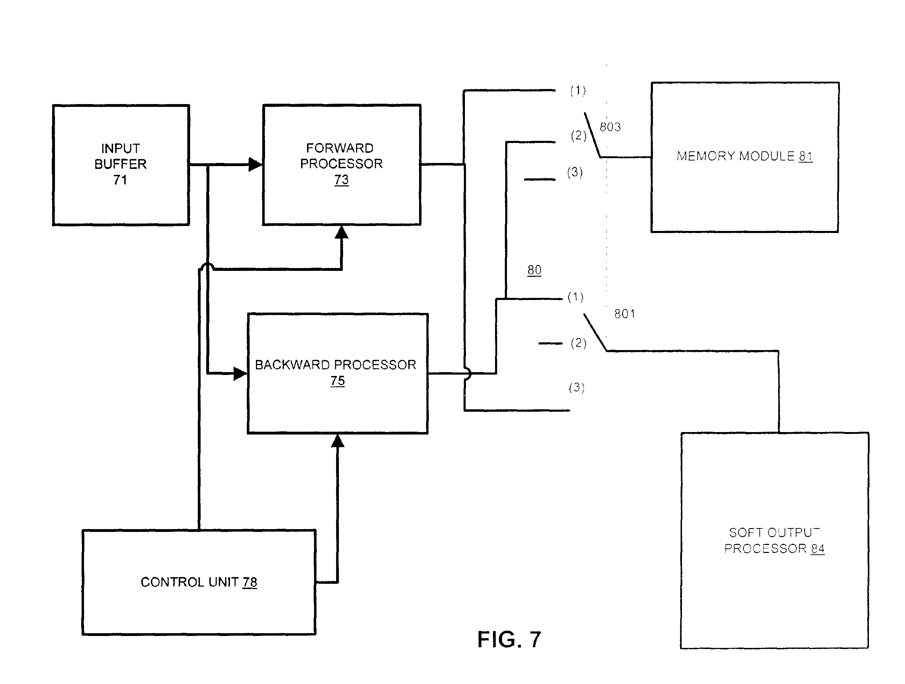

FIG. 7 is a schematic description of system 80 for decoding a sequence of signals output by a convolutional encoder and transmitted over a channel according to a preferred embodiment of the invention. System 80 comprising input buffer 71, forward processor 73, backward processor 75, control unit 78, switching unit 80 memory module 81 and a soft output processor 84. Input buffer 71, forward processor 73, backward processor 75 and memory module 81 of FIG. 7 are analogues of input buffer 71. forward processor 73, backward processor 75 and memory module 81 of FIG. 6.

A man skilled in the art knows how to implement forward processor 73, backward processor 75. soft output processor 84 and dual soft output processor 83.

Conveniently, switching unit 80 comprises of two switches — memory switch 803 and soft switch 801. According to control signals from control unit 78, memory switch 803 can couple memory module 81 to forward processor 73 (state "1"), to backward processor 75 (state "2") or can isolate the input of memory module 81 (state "3"). According to control signals from control unit 78, soft switch 801 can couple the soft output processor 84 to backward processor 75 (state "1"), to forward processor 73 (state "3") or can isolate the input of soft output decoder 84 (state "2").

During learning periods of forward and backward processors 73 and 75 the alphas and betas are not valid. Conveniently they are not stored in memory module 81. Preferably, during learning periods, control unit 78 sends control signals to switching unit 80 so that the outputs backward processor 75 and forward processor 73 are not coupled to memory module 81 and double soft output processor 83. Soft switch 801 is at state "2" and memory switch 801 is at state switches are at state "3".

When forward processor 73 computes alphas of nodes of a stage and the betas of the adjacent stage haven't been previously computed the alphas are sent to memory module 81. Conveniently, memory switch is at state "1" and the output of forward processor 73 is coupled to memory module 81.

When backward processor 75 computes betas of nodes of a stage and the alphas of the adjacent stage haven't been previously computed the betas are sent to memory module 81. Conveniently, memory switch 803 is at state "2" and the output of backward processor 73 is coupled to memory module 81.

When forward processor 73 computes alphas of nodes of a stage and the betas of the adjacent stage have been previously computed, the alphas are sent to soft output processor 84. Soft output processor 84 reads the betas of these nodes from memory module and computes lambda. Conveniently, soft switch is at state "3" and the output of forward processor 73 is coupled to soft output processor 84.

When backward processor 75 computes betas of nodes of a stage and the alphas of the adjacent stage have been previously computed the betas are sent to soft output processor 84. Soft output processor 84 reads the alphas of these nodes from memory module 81 and computes lambda. Conveniently, soft switch is at state "1" and the output of backward processor 75 is coupled to soft output processor 84.

Conveniently, when one of forward processor 73 and backward processor 75 provides valid results to memory module 81 the other processor provides valid results to soft output processor 84. Soft output processor 84 calculates lambdas when an alpha and a beta of a node are provided to it, either from memory module 81 or from one of forward and backward processors 73 and 75. Methods 20-60 can also be performed by other devices, such as but not limited to. multi-flow processors and Very Long Instruction Word processors.

System 70 of FIG. 6 and system 80 of FIG. 7 are especially effective when L<W, thus most of their time the various processors provide valid results. Research and simulations have shown that W is about 4-10 times bigger than L.

System 70 and system 80 are adapted to perform either one of methods 20-60. Conveniently, memory module 81 can be reduced if either one of these systems is configured to perform methods 40-60.

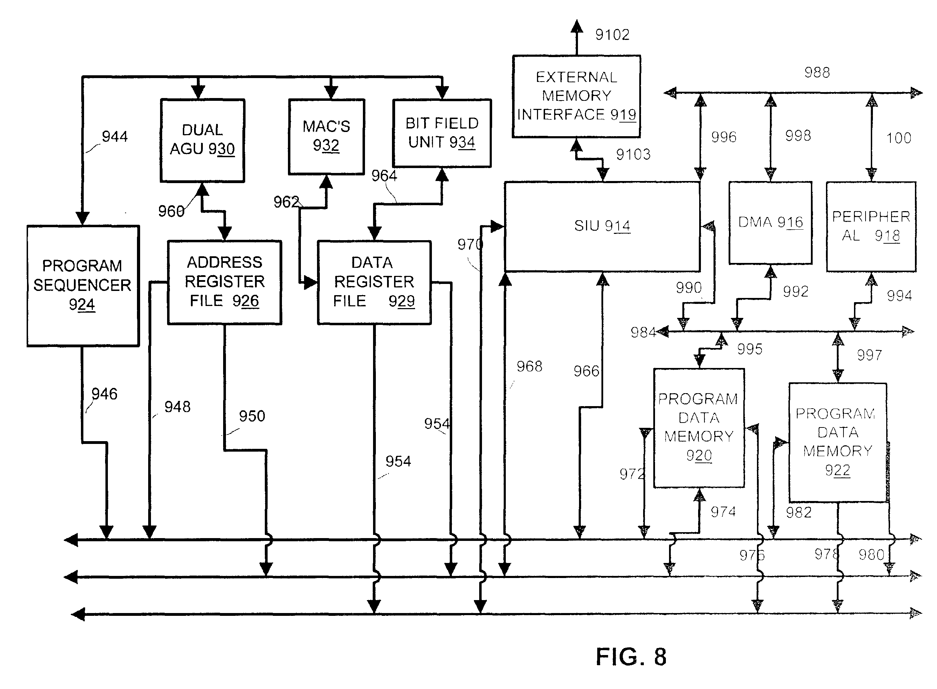

Referring to FIG. 8, an embodiment of a processing system 910 is illustrated. The processing system 910 includes a processor core 912, a system interface unit (SIU) 914, a direct memory access unit 916, a peripheral 918, such as a serial communication port or timer, internal memory modules 920, 922, and an external memory interface module 919. The processing system 910 may also be referred to as a data processor.

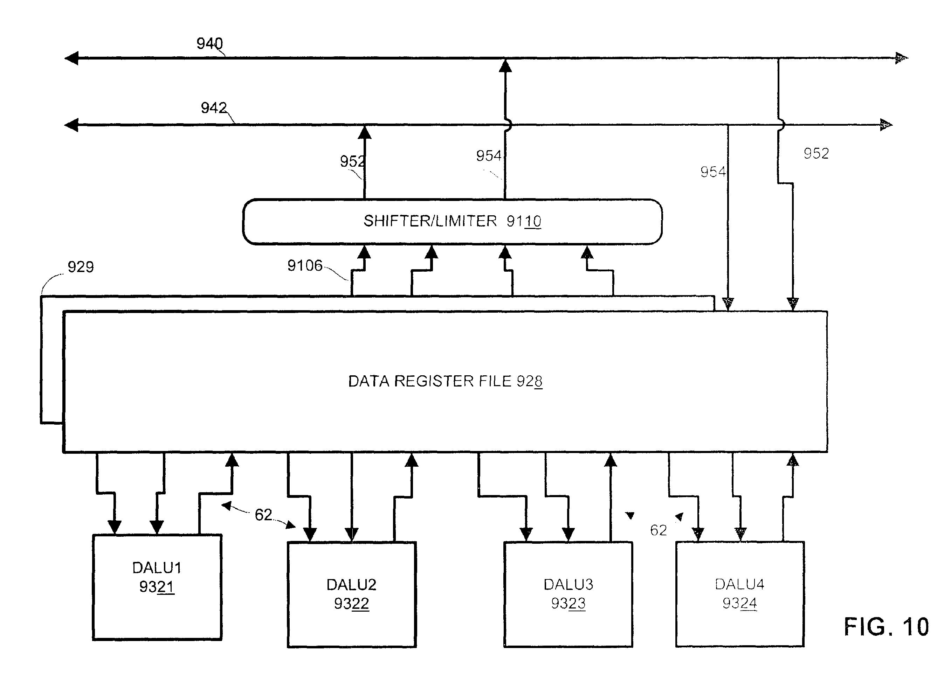

Processor core 912 includes address register file 926, program sequencer 924, data register files 928, 929 (the latter register file is shown in FIG. 10), address arithmetic logic units 930 (also referred to as address generation units (AGU)), multiply and accumulate (MAC) units (932) (also referred to generally as data arithmetic logic units (DALU)), AND bit field and logic unit 934. The address ALUs 930 are coupled to the address register file 926 via internal bus 960. The multiply and accumulate units 932 are coupled to the data register files 928, 929 via internal bus 962, and bit field unit 934 is coupled to the data register files 928, 929 via internal bus 964. The program sequencer 924 is coupled via the instruction bus 944 to the address ALUs 930, the DALUs 932, the bit field unit 934, and the instruction expansion accelerator 936.

Processing system 910 has a scalable architecture that allows it to increment the number of MAC units and AGU units accordingly. For convenience of explanation, FIGS. 8-12 show only a dual MAC unit configuration of processing system 910. The addition of MAC units allows to perform more operations in parallel, and reduced the speed of performing the MAP algorithm.

The system 910 further includes program bus 938, first data bus 940, second data bus 942, peripheral bus 988, direct memory access (DMA) bus 984, and external memory interface bus 9102. Program bus 938 is coupled to program sequencer 924 via bus 946, to SIU 914 via bus 966, and to internal memory 920, 922 via buses 972 and 982 respectively. Data buses 940, 942 are coupled to address register file 926 via buses 948, 950 to data register files 928, 929 via buses 952, 954 and to instruction expansion accelerator 936 via buses 956, 958. Data buses 940, 942 are coupled to memory 920, 922 via buses 974-980.

DMA bus 984 is coupled to SIU 914 via bus 990, to DMA 916 via bus 992, to peripheral unit 918 via bus 994, and to memory units 920, 922 via buses 995 and 997 respectively. Peripheral bus 988 is coupled to the SIU 914 via bus 996, to DMA 916 via bus 998, and to peripheral unit 918 via bus 9100. External memory bus 9102 is coupled to external memory interface module 919 and is coupled to external memory (not shown) in communication with the system 910. In the illustrated embodiment, the program bus 938 is 9128 bits wide, and the other buses 940, 942, 984, and 988 are 964 bits wide. For convenience of explanation, the buses which are used to exchange addresses were not shown.

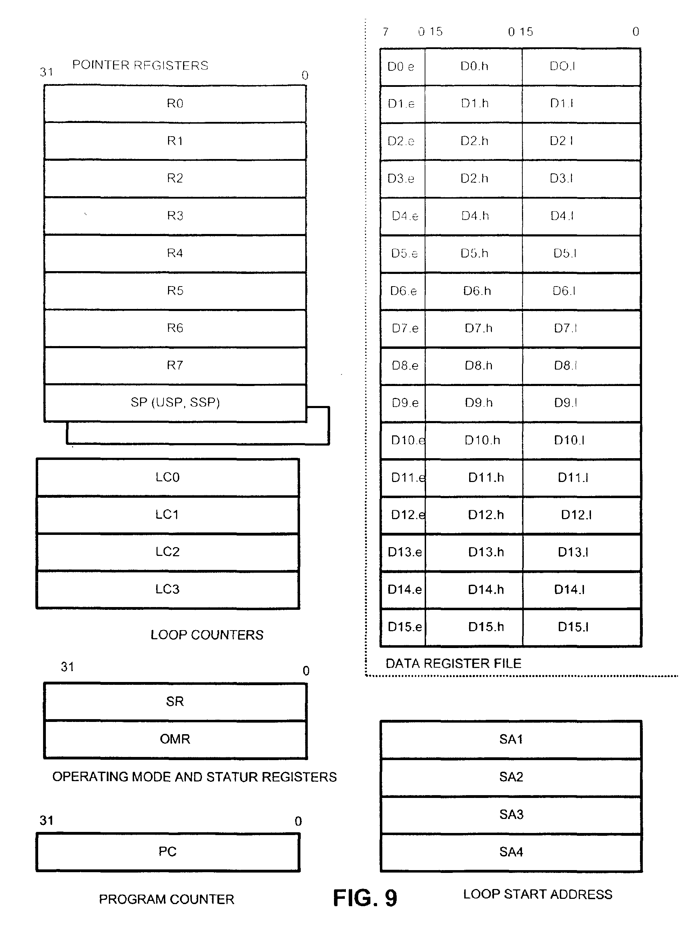

Referring to FIG. 9, a particular embodiment of registers within the core 912 of the system 910 is disclosed. As illustrated, the address register file 926 includes registers R0-R7, stack pointer (SP), N0-N3, M0-M2, MCTL, SAO-SA3, LCO-LC3. The program sequencer 924 includes the program counter, status register, and operating mode and status registers. The data register file 928 includes registers D0-D7 and the data register file 929 includes registers D8-D15. In an alternative embodiment, only a single register file may be used to save cost, such as with the one or two MAC configurations. In other high performance applications, more than two register files may also be used.

FIG. 10 is a schematic diagram of the data register files, four ALU units and shifter/limiter. It is to he understood that the present invention is not to be limited by the above exemplary configurations and is not limited to the particular number of MAC units 32 or the particular arrangements thereof. Shifter/limiter 9110 is used to perform a Viterbi shift left operation on the survivor trellis value, and to insert a predetermined bit to the least significant bit of the survivor trellis value.

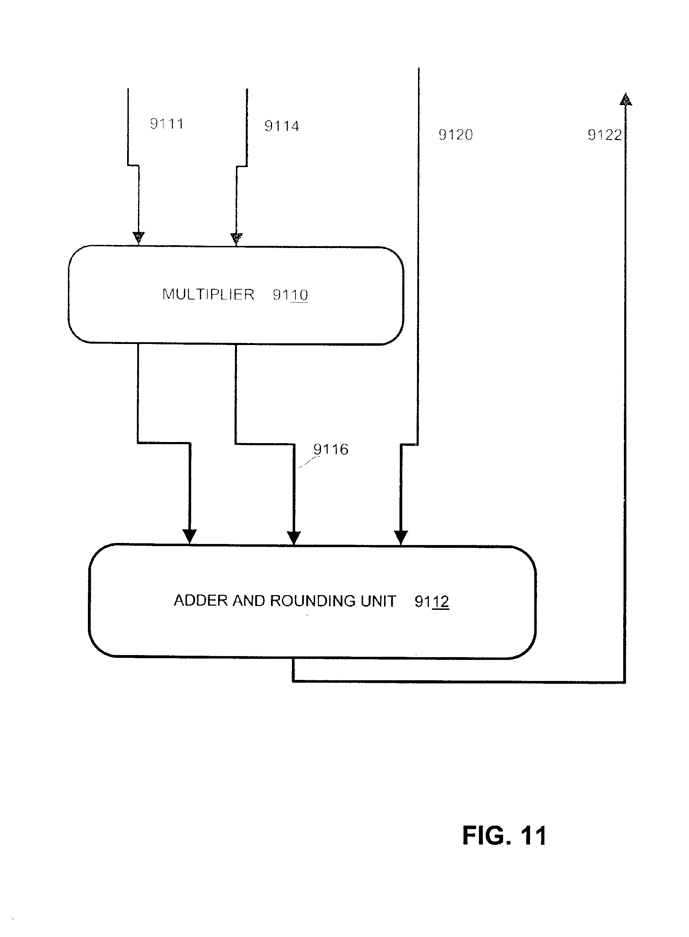

Referring to FIG. 11, a particular embodiment of a MAC unit 932 is illustrated. The MAC unit 932 includes a multiplier 9110 and an adder 9112. The multiplier 9110 receives data input from the data register files 928, 929, and multiplies the data elements 9111, 9114 to produce a multiplied output 9116 that is input to the adder 9112. The adder sums a second data input 9120 and the multipher result 9116 to produce an accumulated result 9122 that is output back to the data register file 28, 29.

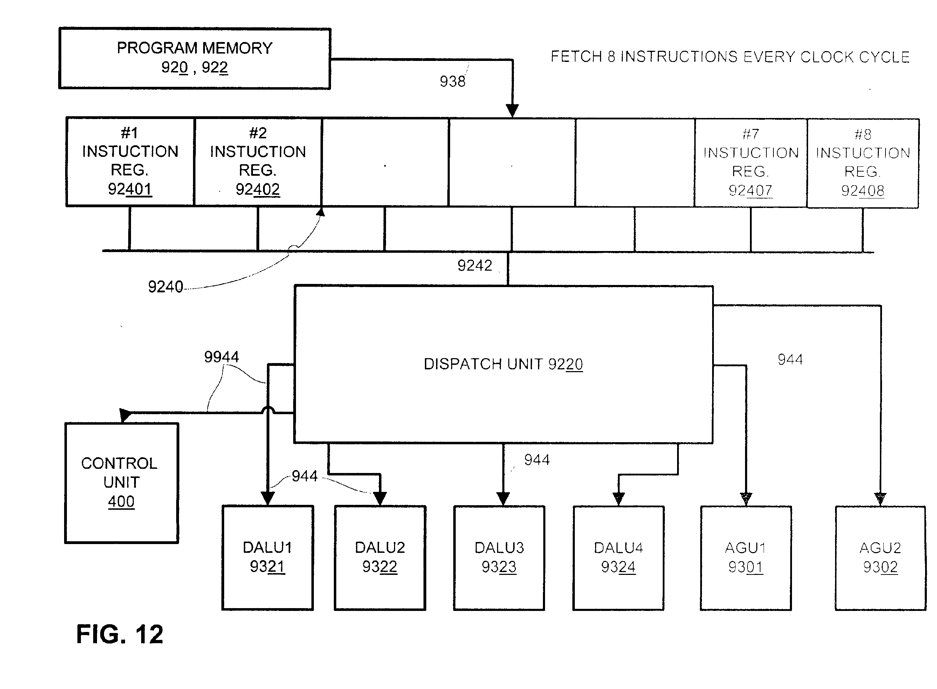

Referring to FIG. 12, illustrating a dispatch unit, and a dispatch operation for the core of the system of FIG. 8. Internal memory 920 and 922 store instruction fetch sets. Preferably, each instruction fetch set comprises of fixed number of instructions. An instruction execution set is usually a subset of an instruction fetch set, usually a single instruction fetch set is comprised of a single instruction execution set, but can also have instructions from other instruction execution sets. An instruction execution set comprises of a plurality of instructions which can be executed in parallel by the various execution units within system 910.

The embodiment illustrates a dispatch unit 220, eight instruction registers 2401-2409, collectively denoted 9240, for storing eight instructions every clock cycle, a program memory (either program memory 920 or 922), various data arithmetic logic units (DALUs) 9321-9324 (collectively denoted 932 in FIG. 1), address generation units (AGUs) 9301-9302, 9324 (collectively denoted 930 in FIG. 1), and control unit 940. The dispatch unit 9220 and instructions registers 9240 may form the program sequencer 924. In the illustrated embodiment, dispatch unit 9220 groups the instructions into execution sets, and then simultaneously dispatched them via a routing mechanism to the appropriate execution units 9301-9302, 9321-9324, for parallel decoding and execution. Simultaneous dispatch means that execution of each of the grouped instructions is initiated during a common clock cycle. In the illustrated embodiment of the system 910, execution of each of the grouped instructions is initiated during a common clock cycle, but one or more of the grouped instructions may complete execution during a different clock cycle.

System 910 uses a pipeline execution method that includes the execution stages of program pre-fetch, program fetch, dispatch and decode, address generation, and execute.

System 910 ability to perform several operations in parallel, allows it to perform TC in a parallel manner. System 910 in a four MAC configuration and two dual MAC configured systems 910 are adapted to perform either one of methods 20-60. System 910 in a dual MAC configuration performs portions of steps 25. 35. 46. 53 and 63 in a serial manner.

The calculations of the TC is conveniently based upon the following exemplary instructions:

MOVE.2L (R)-N0, D1: D2 instruction moves two 16-bit words from a memory location within internal memory module, pointed by register R, to destination registers D1 and D2. The content of register R in incremented by N0 after the two words are moved to registers D1 and D2. MOVE.2L is the operation code.

R, D1, D2 and D3,D4 are registers which are located either in address register 26 file and the data register files 28, 29.

TFR D1:,D2 instruction transfers the content of a register D1 to register D2. TFR is the operation code.

ADD2 D1: D2 adds the content of the F/2 most significant bits (i.e.- D1.h) of F- bit register D1 to the F/2 most significant bits of register D2 (i.e.- D2.h), stores the result at D1.h, adds the content of the F/2 least significant bits (i.e.- D1.1) of register D1 to the F/2 least significant bits of register D2 (i.e.- D2.1) and stores the result at D1.1. Carry is disabled between the F/2 least significant bit and the F/2 most significant bit of D2. ADD2 is the operation code.

SUB2 D1: D2 subtracts the content of the D2.h from D1.h, stores the result at D1.h, subtracts the content of D2.1 from the content of D1.1 and stores the result at D1.1. Carry is disabled between the F/2 least significant bit and the F/2 most significant bit of D2. SUB2 is the operation code.

MAX2 D1: D2 performs two comparisons. It compares between the contents of D1.1 and D2.1, and if the former is greater than the latter the content of the latter is moved to D2.1 and a flag is reset, else the flag is set. It also compares between the contents of D1.h and D2.h, and if the former is greater than the latter the content of the is moved to D2.h and another flag is reset, else the other flag is set. Preferably, the registers which their content is involved in the comparison determine which flags are set/reset as a result of the two comparisons.

An exemplary assembly code (written in capital letters), and a detailed explanation of each code line, and of each instruction are shown. This assembly code performs alpha, betas and lambda calculations associated with a plurality of nodes such as four nodes of starting stage of trellis n00, n01, n02, n03, four nodes of a second stage of the trellis n10, n11, n12, n13, four nodes of ending stage of the trellis nT0, nT1, nT2, nT3, and four nodes of the (T-1) 'th stage of the trellis nS0, nS1, nS2, nS3. S=T-1. Whereas : $\alpha0$, $\alpha1$, $\alpha2$ and $\alpha3$ are the forward metrics of n00, n01, n02 and n03. $\beta0$, $\beta1$, $\beta2$ and $\beta3$ are the backward metrics of nT0, nT1, nT3 and nT4, $\gamma00$ is the branch metric associated with the transition from n00 to n12, from n01 to n10, $-\gamma00$ is the branch metric associated with the transition from n00 to n10, from n01 to n12, $\gamma01$ is the branch metric associated with the transition from n02 to n11, from n03 to n13, $-\gamma01$ is the branch metric associated with the transition from n02 to n11, from n03 to n11, , $\gamma T0$ is the branch metric associated with the transition from nT0 to nS2, from nT1 to nS0, $-\gamma T0$ is the branch metric associated with the transition from nT0 to nSO, from nT1 to nS2, $\gamma T1$ is the branch metric associated with the transition from nT2 to nS1, from nT3 to nS3, $-\gamma T1$ is the branch metric associated with the transition from nT2 to nS1, from nT3 to nS1, $\gamma10$ is the branch metric associated with the transition from n10 to n22, from n11 to n20, $-\gamma10$ is the branch metric associated with the transition from n10 to n20, from n11 to n22, $\gamma11$ is the branch metric associated with the transition from n12 to n21, from n13 to n23, $-\gamma11$ is the branch metric associated with the transition from n12 to n21, from n13 to n23.

// perform ADD part of ACS operation for backward recursion. Save calculated forward state metrics.

After the execution of this instruction execution set D2.h stores $\beta1+\gamma1$, D2.1 stores $\beta0-\gamma T0$, D3.h stores $\beta3+\gamma T1$, D3.1 stores $\beta2-\gamma T0$, D7.h stores $\beta1-\gamma T1$, D7.1 stores $\beta0-\gamma T0$, D6.h stores $\beta3-\gamma T1$, D6.1 stores $\beta2+\gamma T0$.

```
ADD2 D2,D7        SUB2 D7,D2        ADD2 D3,D6        SUB2 D6, D3

MOVE.2W (R2), D4 D5        MOVES.2F (R3)-N1, D4 D5
```

// Complete ACS operation for backward recursion. Copy branch metrics for forward recursion to the relevant registers. Read current forward state metrics. Read forward recursion branch metrics for the next step.

After the execution of this instruction execution set D7.h stores $\beta3$, D7.1 stores $\beta1$, D6.h stores $\beta2$, D6.1 stores $\beta0$, D4.h stores $-\gamma01$, D7.1 stores $\gamma10$, D5.h stores $\gamma01$, D5.1 stores $\gamma00$. D8.h stores $-\gamma11$, D8.1 stores $\gamma10$, D0.h stores $\alpha2$, D0.1 stores $\alpha0$, D1.h stores $\alpha3$, D1.1 stores $\alpha1$.

MAX2 D2,D6    MAX2 D3,D7    TFR D8. D4 TFR D8,D5    MOVE.2L

(R2)+, D0, D1 MOVE.L (R0)— . D8

// Perform ADD part of ACS operation for forward recursion. Save Calculated backward state metrics.
After the execution of this instruction execution set D0.h stores $\alpha2+\gamma01$, D0.1 stores $\alpha0-\gamma00$, D1.h stores $\alpha3+\gamma01$, D1.1 stores $\alpha1-\gamma00$, D4.h stores $\alpha3-\gamma01$, D4.1 stores $\alpha1+\gamma00$, D5.h stores $\alpha2-\gamma01$, D5.1 stores $\alpha0+\gamma00$.

ADD2 D0,D5    SUB2 D5,D0    ADD2 D1,D4    SUB2 D4, D1

MOVE.2W (R2), D6 D7    MOVES.2F (R3)+N1, D6 D7

// Complete ACS operation for forward recursion. Copy branch metrics for backward recursion to relevant registers. Read current backward state metrics.
Read backward recursion branch metrics for the next step.
After the execution of this instruction execution set D4.h stores $\alpha1$, D4.1 stores $\alpha0$, D5.h stores $\alpha3$, D5.1 stores $\alpha2$, D7.h stores $-\gamma T1$ D7.1 stores $\gamma T0$, D6.h stores $-\gamma T1$, D6.1 stores $\gamma T0$, D9.h stores $-\gamma S1$, D9.1 stores $\gamma S0$, D2.h stores $\beta1$, D2.1 stores $\beta0$, D3.h stores $\beta3$, D3.1 stores $\beta2$.

MAX2 D0,D4    MAX2 D1,D5    TFR D9, D6    TFR D9,D7    MOVE.2L

(R2)+, D2, D3    MOVE.L (R1)-,D9

It should be noted that the particular terms and expressions employed and the particular structural and operational details disclosed in the detailed description and accompanying drawings are for illustrative purposes only and are not intended to in any way limit the scope of the invention as described in the appended claims.
Thus, there has been described herein an embodiment including at least one preferred embodiment of an improved method and apparatus for implementing a method and a device for performing parallel SISO decoding. It will be apparent to those skilled in the art that the disclosed subject matter may be modified in numerous ways and may assume many embodiments other then the preferred form specifically set out and described above.
Accordingly, the above disclosed subject matter is to be considered illustrative and not restrictive, and to the maximum extent allowed by law, it is intended by the appended claims to cover all such modifications and other embodiments which fall within the true spirit and scope of the present invention. The scope of the invention is to be determined by the broadest permissible interpretation of the following claims and their equivalents rather then the foregoing detailed description.

**Claims**

**1.** A method for performing SISO decoding, the method comprising the steps of:

(a) providing a trellis representative of an output of a convolutional encoder, the convolutional encoder has a coding rate of R, the trellis having a block length T;
(b) assigning an initial conditions to each starting node of the trellis for a forward iteration through the trellis and assigning an initial condition to each ending node of the trellis for a backward iteration through the trellis; and
(c) computing a forward metric for each node, starting from the start of the trellis and advancing forward through the trellis and a computing backward metric for each node, starting from the end of the trellis and advancing backwards through the trellis; wherein when forward metrics of nodes of a stage are computed and backward metrics of nodes of an adjacent stage were previously computed, the computation of forward metrics is integrated with the computation of a lambda from the stage to the adjacent stage, wherein when backward metrics of nodes of a stage are computed and the forward metrics of the nodes of an adjacent stage were previously computed, the computation of backward metrics is integrated with the computation of lambda from the stage to the adjacent stage.

**2.** The method of claim 1 wherein the method is used to implement one of the Log MAP algorithms.

**3.** The method of claim 1 wherein branch metrics are computed during step 1(c).

**4.** The method of claim 1 wherein step 1(c) is executed after receiving T/R signals.

**5.** A method for performing SISO decoding, the method comprising the steps of:

(a) providing a trellis representative of an output of a convolutional encoder, the trellis having a block length T, the convolutional encoder has a coding rate of R;
(b) assigning an initial conditions to each starting node of the trellis for a forward iteration through the trellis and assigning an initial condition to each ending node of the trellis for a backward iteration through the trellis; and
(c) computing a forward metric for each node, starting from the start of the trellis and advancing forward through a first half of the trellis and computing a backward metric for each node, starting from the end of the trellis and advancing backwards through a second half of the trellis; and
(d) computing a backward metric for each node, and computing a lambda for each transition from a stage to an adjacent stage starting from an end of the first half of the trellis and advancing backwards and computing a forward metric for each node and a lambda for each transition from a stage to an adjacent stage, starting from a start of the second half of the trellis and advancing forwards.

**6.** The method of claim 5 wherein the method is used to implement one of the Log MAP algorithms.

**7.** The method of claim 5 wherein branch metrics are computed during step 5(c).

**8.** The method of claim 5 wherein step 5(c) is executed after receiving T/R signals.

**9.** A method for performing SISO decoding, the method comprising the steps of:

(a) providing a trellis representative of an output of a convolutional encoder having a coding rate of Q, the trellis having a block length T;
(b) assigning an initial condition to each node of a (j-L)'th stage of the trellis for a forward iteration through the trellis and assigning an initial condition to each node of a (i +L)'th stage of the trellis for a backward iteration through the trellis; wherein L is a length of a learning period, a forward window of length W starts at a j'th stage of the trellis and ends at a (j+W)'th stage of the trellis, a backward window of length W starts at a i'th stage of the trellis and ends at a (i-W)'th stage of the trellis;
(c) computing a forward metric for a each node, starting from the (j-L)'th stage of the trellis and ending at the (j-W)'th stage of the trellis and computing a backward metric of a plurality each node, starting from the (i +L)'th stage of the trellis and ending at the (i-W)'th stage of the trellis;
(d) assigning an initial condition to each node of a (j+L+W)'th stage of the trellis for a backward iteration through the trellis and assigning an initial condition to each node of a (i-W-L)'th stage of the trellis for a forward iteration through the trellis;
(e) computing a backward metric for each node, starting from the (j+L+W)'th stage of the trellis and ending at the (j+W+1)'th stage of the trellis and computing a forward metric of each node, starting from the (i - L-W )'th stage of the trellis and ending at the (i-W-1)'th stage of the trellis;
(f) computing a backward metric for each node and computing a lambda for each transition from a stage to an adjacent stage, starting from the (j+W)'th node and ending at the j'th node, computing a forward metric for each node and computing a lambda for each transition from a stage to an adjacent stage, starting from the (i-W)'th node and ending at the i'th stage of the trellis; and
(g) updating j and i and repeating steps 9(b) - 9(f) until each lambda of the trellis is calculated.

**10.** The method of claim 9 wherein the method is used to implement one of the Log MAP algorithms.

**11.** The method of claim 9 wherein branch metrics are computed during step 5(c).

**12.** The method of claim 9 wherein step 9(c) is executed after receiving T R signals.

**13.** The method of claim 9 wherein step 9(c) is executed after receiving enough signal samples to initiate a backward and forward recursion through the trellis.

**14.** The method of claim 9 wherein L<W.

**15.** The method of claim 9 wherein if any variable out of (j-L), (j-W-L), (j-1), (i-1), (i-W) is negative it is mapped to 1 and if any variables out of (i+L). (j-W) and (j+L+W) is greater than T, it is mapped to T.

**16.** The method of claim 9 wherein during a first iteration of step 9(b) j=0, i=T and a first step 9(c) involves computing a forward metric for a each node, starting from the starting stage of the trellis and ending at the (W)'th stage of the trellis and computing a backward metric of a plurality each node, starting from the T'th stage of the trellis and ending at the (T-W+1)'th stage of the trellis.

**17.** A method for performing SISO decoding, the method comprising the steps of:

(a) providing a trellis representative of an output of a convolutional encoder, the trellis having a block length T;
(b) assigning an initial condition to each node of a (j-L)'th stage of the trellis for a forward iteration through the trellis and assigning an initial condition to each node of a (i +L)'th stage of the trellis for a backward iteration through the trellis; wherein L is a length of a learning period, a forward window of length W starts at a j'th stage of the trellis and ends at a (j+W)'th stage of the trellis, a backward window of length W starts at a i'th stage of the trellis and ends at a (i-W)'th stage of the trellis;
(c) computing a forward metric for a each node, starting from the (j-L)'th stage of the trellis and ending at the (j+W)'th stage of the trellis and computing a backward metric of a plurality each node, starting from the (i +L) 'th stage of the trellis and ending at the (i-W)'th stage of the trellis: wherein when forward metrics of nodes of a stage are computed and the backward metrics of the nodes of an adjacent stage were previously computed, the computation of forward metrics is integrated with the computation of lambda from the stage to the adjacent stage. wherein when backward nodes of a stage are computed and the forward metrics of the nodes of an adjacent stage were previously computed. the computation of backward nodes is integrated with the computation of lambda from the stage to the adjacent stage; and
(d) updating j and i and repeating steps 15(b) — 15(c) until each lambda of the trellis is calculated.

**18.** The method of claim 17 wherein the method is used to implement one of the Log MAP algorithms.

**19.** The method of claim 17 wherein branch metrics are computed during step 5(c).

**20.** The method of claim 17 wherein step 17(c) is executed after receiving T/R signals.

**21.** The method of claim 17 wherein step 17(c) is executed after receiving enough signal samples to initiate a backward and forward recursion through the trellis.

**22.** The method of claim 17 wherein L<W.

**23.** The method of claim 17 wherein if any variable out of (j-L), (j-W-L), (j-1), (i-1), (i-W) is negative it is mapped to 0 and if any variables out of (i+L), (j+W) and (j+L+W) is greater than T, it is mapped to T.

**24.** The method of claim 17 wherein during a first iteration of step 9(b) j=0, i=T and step 17(c) involves computing a forward metric for a each node, starting from the first stage of the trellis and ending at the W'th stage of the trellis and computing a backward metric of a plurality each node, starting from the T'th stage of the trellis and ending at the (T-W—1) stage of the trellis

**25.** A method for performing SISO decoding, the method comprising the steps of:

(a) providing a trellis representative of an output of a convolutional encoder having coding rate R, the trellis having a block length T;
(b) assigning an initial condition for forward iteration through the trellis. to each node of a first group of stages, each stage of first group of stages being located L stages before a starting stage of a forward window out of a group of forward windows, assigning an initial condition for a backward iteration through the trellis, to each node of a second group of stages, each stage of the second group of stages being located L stages after an ending stage of a backward window out of a group of backward windows, wherein L is a length of a learning period, each forward window and each backward window is W stages long;

(e) computing a forward metric for each node, starting from the first group of stages and ending at a third group of ending stages of the group of forward windows, and computing a backward metric for each node, starting from the second group of stages and ending at a fourth group of ending stages of the group of the backward windows; wherein when forward metrics of nodes of a stage are computed and backward metrics of nodes of an adjacent stage were previously computed, the computation of forward metrics is integrated with the computation of a lambda from the stage to the adjacent stage, wherein when backward metrics of nodes of a stage are computed and the forward metrics of the nodes of an adjacent stage were previously computed, the computation of backward metrics is integrated with the computation of lambda from the stage to the adjacent stage; and

(f) selecting new first, second, third and fourth groups and repeating steps 25(b) — 25(c) until each lambda of the trellis is calculated.

26. The method of claim 25 wherein branch metrics are computed during step 25(c).

27. The method of claim 25 wherein step 25(c) is executed after receiving T/R signals.

28. The method of claim 25 wherein step 25(c) is executed after receiving enough signal samples to initiate a backward and forward recursion through the trellis.

29. The method of claim 25 wherein L<W.

30. The method of claim 25 wherein if any variable out of (j-L), (j-W-L), (j-1), (i-1), (i-W) is negative it is mapped to 1 and if any variables out of (i+L), (j+W) and (j+L+W) is greater than T, it is mapped to T.

31. A system for decoding a sequence of signals output by a convolutional encoder and transmitted over a channel, the encoder output represented by a trellis having a block length T, the system comprising :

input buffer, adapted to receive the sequence of signals and store at least a portion of the sequence of signals;
a forward processor, coupled to the input buffer, adapted to receive signals being stored in the input buffer and calculate forward metrics;
a backward processor, adapted to receive signals being stored in the input buffer and calculate backward metrics;
a memory module, adapted to store forward and backward metrics, provided by the forward processor and the backward processor;
a double soft output processor, coupled to the memory module, to the forward processor and to the backward processor, adapted to receive forward metrics and backward metrics and to calculate at least two lambdas at a time and to provide a the at least two lambdas; and
control unit, coupled to the forward processor and to the backward processor, for determining whether the forward metrics and the backward metrics provided by the forward processor and the backward processor are to be either stored. provided to the double soft output processor or be ignored.

32. The system of claim 31 wherein the forward processor and the backward processor are coupled to the double soft output processor via a switching unit, the switching unit is controlled by the control unit.

33. A system for decoding a sequence of signals output by a convolutional encoder and transmitted over a channel, the encoder output represented by a trellis having a block length T, the system comprising :

input buffer, adapted to receive the sequence of signals and store at least a portion of the sequence of signals;
a forward processor, coupled to the input buffer, adapted to receive signals being stored in the input buffer and calculate forward metrics;
a backward processor, adapted to receive signals being stored in the input buffer and calculate backward metrics;
a memory module, adapted to store forward and backward metrics, provided by the forward processor and the backward processor;
a soft output processor, coupled to the memory module, to the forward processor and to the backward processor, adapted to receive forward metrics and backward metrics, to calculate lambda and to provide the lambda; and

control unit, coupled to the forward processor and to the backward processor, for determining whether the forward metrics and the backward metrics provided by the forward processor and the backward processor are to be either stored, provided to the soft output processor or be ignored.

PROVIDING TRELLIS T
21

22

ASSIGNING INITIAL CONDITIONS TO STARTING AND ENDING NODES
23

24

COMPUTING FORWARD METRIC FOR EACH NODE, STARTING FROM TRELLIS START, COMPUTING BACKWARD METRIC FOR EACH NODE, STARTING FROM TRELLIS END.
WHILE COMPUTING A BACKWARD (FORWARD) METRIC FOR NODES OF A STAGE AND FORWARD (BACKWARD) METRICS OF NODES OF AN ADJACENT STAGE WERE PREVIOUSLY COMPUTED, ALSO COMPUTING LAMBDA FOR THE TRANSITION FROM THE STAGE TO THE ADJACENT STAGE

25

20

**FIG. 1**

PROVIDING TRELLIS T
31

32

ASSIGNING INITIAL CONDITIONS TO STARTING AND ENDING NODES
33

34

COMPUTING FORWARD METRIC FOR EACH NODE, STARTING FROM
TRELLIS START AND THROUGH A FIRST HALF OF THE TRELLIS ;
COMPUTING BACKWARD METRIC FOR EACH NODE, STARTING FROM
TRELLIS END AND THROUGH A SECOND HALF OF THE TRELLIS
35

36

COMPUTING A BACKWARD METRIC FOR EACH NODE AND LAMBDA FOR A
TRANSITION FROM A STAGE TO AN ADJACENT STAGE, THROUGH THE
FIRST HALF OF THE TRELLIS AND COMPUTING A FORWARD METRIC FOR
EACH NODE LAMBDA FOR A TRANSITION FROM A STAGE TO AN ADJACENT
STAGE, THROUGH THE SECOND HALF OF THE TRELLIS
37

30

**FIG. 2**

PROVIDING TRELLIS T
41

41'

ASSIGNING INITIAL CONDITIONS TO NODES
OF (j-L)'TH AND (i+L)'TH STAGES OF TRELLIS 42

42'

COMPUTING FORWARD METRIC FOR EACH NODE, FROM (j-L)'TH STAGE TO (j+W)'TH
STAGE COMPUTING BACKWARD METRIC FOR EACH NODE, STARTING FROM (i+L)'TH
STAGE TO (i-W)'TH STAGE      43

-43'

ASSIGNING INITIAL CONDITIONS TO STARTING AND ENDING NODES
OF (j+L+W)'TH AND (i-L-W)'TH STAGES OF TRELLIS 44

44'

COMPUTING FORWARD METRIC FOR EACH NODE, FROM (i-L-W)'TH STAGE TO (i-1-W)'TH
STAGE . COMPUTING BACKWARD METRIC FOR EACH NODE, STARTING FROM (j+L+W)'TH
STAGE TO (j+W+1)'TH STAGE      45

45'

COMPUTING A BACKWARD METRIC FOR EACH NODE, AND A LAMBDA FOR A TRANSITION
FROM A STAGE TO AN ADJACENT STAGE, FROM (j+W)'TH STAGE TILL j'TH STAGE.
COMPUTING A FORWARD METRIC FOR EACH NODE AND A LAMBDA FOR A TRANSITION
FROM A STAGE TO AN ADJACENT STAGE FOR EACH NODE, FROM THE (i-W)'TH STAGE
TILL THE i)'TH STAGE 46

46'

UPDATE i, j      47

47'

NO

WERE LAMBDAS OF ALL TRELLIS COMPUTED ?
48

48'

40

**FIG. 3**

PROVIDING TRELLIS T
51

51'

ASSIGNING INITIAL CONDITIONS TO NODES
OF (j-L)'TH AND (i+L)'TH STAGES OF TRELLIS 52

52'

COMPUTING FORWARD METRIC FOR EACH NODE, FROM (j-L)'TH STAGE TO
(j+W)'TH STAGE . COMPUTING BACKWARD METRIC FOR EACH NODE,
STARTING FROM (i+L)'TH STAGE TO (i-W)'TH STAGE
WHILE COMPUTING A BACKWARD (FORWARD) METRIC FOR NODES OF A
STAGE AND FORWARD (BACKWARD) METRICS OF NODES OF AN ADJACENT
STAGE WERE PREVIOUSLY COMPUTED, ALSO COMPUTING LAMBDA FOR A
TRANSITION FROM THE STAGE TO ADJACENT STAGE
53

53'

UPDATE i, j          54

54'

WERE LAMBDAS OF ALL TRELLIS COMPUTED ?
55

NO

55'

50

**FIG. 4**

PROVIDING TRELLIS T
61

61'

ASSIGNING INITIAL CONDITIONS TO NODES
OF FIRST GROUP OF STAGES LOCATED L STAGES BEFORE STARTING
STAGES OF A FORWARD WINDOWS STAGES OF TRELLIS AND TO NODES
OF SECOND GROUP OF STAGES LOCATED L STAGES AFTER ENDING
STAGES OF A BACKWARD WINDOWS  62

62'

COMPUTING FORWARD METRIC FOR EACH NODE, FROM FIRST GROUP OF
STAGES TO A THIRD GROUP OF ENDING STAGES OF THE GROUP OF
FORWARD WINDOWS. COMPUTING BACKWARD METRIC FOR EACH NODE,
STARTING SECOND GROUP OF STAGES AND ENDING AT A FOURTH GROUP
OF ENDING STAGES OF THE GROUP OF THE BACK WARD WINDOWS
WHILE COMPUTING A BACKWARD (FORWARD) METRIC FOR NODES OF A
STAGE AND FORWARD (BACKWARD) METRICS OF NODES OF AN ADJACENT
STAGE WERE PREVIOUSLY COMPUTED, ALSO COMPUTING LAMBDA
FOR A TRANSITION FROM THE STAGE TO ADJACENT STAGE

63

63'

SELECT NEW GROUPS          64

64'

NO

WERE LAMDBAS OF ALL TRELLIS COMPUTED ?
66

66'

60

**FIG. 5**

EP 1 115 209 A1

FIG. 6

FIG. 7

FIG. 8

EP 1 115 209 A1

POINTER REGISTERS

| 31 | 0 |
|---|---|
| R0 | |
| R1 | |
| R2 | |
| R3 | |
| R4 | |
| R5 | |
| R6 | |
| R7 | |
| SP (USP, SSP) | |

| LC0 |
|---|
| LC1 |
| LC2 |
| LC3 |

LOOP COUNTERS

| 7 0 15 | | 0 15 | 0 |
|---|---|---|
| D0.e | D0.h | DO.l |
| D1.e | D1.h | D1.l |
| D2.e | D2.h | D2 l |
| D3.e | D2.h | D3.l |
| D4.e | D4.h | D4.l |
| D5.e | D5.h | D5.l |
| D6.e | D6.h | D6.l |
| D7.e | D7.h | D7.l |
| D8.e | D8.h | D8.l |
| D9.e | D9.h | D9.l |
| D10.e | D10.h | D10.l |
| D11.e | D11.h | D11.l |
| D12.e | D12.h | D12.l |
| D13.e | D13.h | D13.l |
| D14.e | D14.h | D14.l |
| D15.e | D15.h | D15.l |

DATA REGISTER FILE

| 31 | 0 |
|---|---|
| SR | |
| OMR | |

OPERATING MODE AND STATUR REGISTERS

| SA1 |
|---|
| SA2 |
| SA3 |
| SA4 |

| 31 | 0 |
|---|---|
| PC | |

PROGRAM COUNTER

**FIG. 9**

LOOP START ADDRESS

EP 1 115 209 A1

940

942

952 954

954 952

SHIFTER/LIMITER 9110

929

9106

DATA REGISTER FILE 928

62

62

| DALU1 9321 | DALU2 9322 | DALU3 9323 | DALU4 9324 |

FIG. 10

9111    9114    9120    9122

MULTIPLIER    91<u>10</u>

9116

ADDER AND ROUNDING UNIT    91<u>12</u>

**FIG. 11**

PROGRAM MEMORY 920 , 922

FETCH 8 INSTUCTIONS EVERY CLOCK CYCLE

938

| #1 INSTUCTION REG. 92401 | #2 INSTUCTION REG. 92402 | | | | #7 INSTUCTION REG. 92407 | #8 INSTUCTION REG. 92408 |

9240

9242

DISPATCH UNIT 9220

9944

944

CONTROL UNIT 400

944

944

| DALU1 9321 | DALU2 9322 | DALU3 9323 | DALU4 9324 | AGU1 9301 | AGU2 9302 |

FIG. 12

EP 1 115 209 A1

## EUROPEAN SEARCH REPORT

**European Patent Office**

**Application Number**

EP 00 10 0349

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A,D | US 5 933 462 A (SINDHUSHAYANA NAGABHUSHANA T ET AL) 3 August 1999 (1999-08-03)<br>* column 4, line 9 - line 64 *<br>* abstract; figure 4 * | 1-44 | H03M13/29 |
| A | YIIN L ET AL: "MLSE AND SOFT-OUTPUT EQUALIZATION FOR TRELLIS-CODED CONTINUOUS PHASE MODULATION"<br>IEEE TRANSACTIONS ON COMMUNICATIONS,US,IEEE INC. NEW YORK, vol. 45, no. 6, 1 June 1997 (1997-06-01), pages 651-659, XP000659559<br>ISSN: 0090-6778<br>* page 655, right-hand column - page 556, left-hand column, paragraph 1 * | 1-44 | |
| A | LIU Y, FOSSORIER M., LIN S.: "MAP algorithms for decoding linear block codes based on sectionalized trellis diagrams"<br>IEEE GLOBECOM 1998,<br>vol. 1, 8 - 12 November 1998, pages 562-566, XP002142015<br>* the whole document * | 1-44 | **TECHNICAL FIELDS SEARCHED (Int.Cl.7)**<br><br>H03M |

The present search report has been drawn up for all claims

| Place of search | Date of completion of the search | Examiner |
|---|---|---|
| MUNICH | 26 September 2000 | Farman, T |

EP 1 115 209 A1

## ANNEX TO THE EUROPEAN SEARCH REPORT
## ON EUROPEAN PATENT APPLICATION NO.

EP 00 10 0349

This annex lists the patent family members relating to the patent documents cited in the above-mentioned European search report.
The members are as contained in the European Patent Office EDP file on
The European Patent Office is in no way liable for these particulars which are merely given for the purpose of information.

26-09-2000

| Patent document cited in search report | Publication date | Patent family member(s) | | Publication date |
|---|---|---|---|---|
| US 5933462     A | 03-08-1999 | AU | 722477 B | 03-08-2000 |
| | | AU | 5104598 A | 29-05-1998 |
| | | CN | 1236507 A | 24-11-1999 |
| | | EP | 0937336 A | 25-08-1999 |
| | | WO | 9820617 A | 14-05-1998 |

EPO FORM P0459

For more details about this annex : see Official Journal of the European Patent Office, No. 12/82

27